# EUROPEAN PATENT APPLICATION

(11) **EP 1 944 790 A2**
(43) Date of publication of application: **16.07.2008**
(21) Application number: 08250039.8
(22) Date of filing: 07.01.2008
(51) Int. Cl.: H01J 37/317

(54) **Improvements relating to ion implanters**

(30) Priority: 09.01.2007 US 651107
(71) Applicant: Applied Materials, Inc., Santa Clara, CA 95054 (US)
(72) Inventor: Collart, Erik, Ashington West Sussex RH20 3DB (GB); King, Michael John, East Grinstead West Sussex RH19 4DH (GB)
(74) Representative: Cross, Rupert Edward Blount

(57) **Abstract**

The present invention relates to components in ion implanters having surfaces adjacent to the path of the ion beam through the ion implanter. Such surfaces will be prone to deposition and the present invention addresses problems associated with delamination of deposited material. An ion implanter component is provided that has a surface defining at least in part an ion beam path through the ion implanter, wherein at least a portion of the surface has been roughened. The portion of the surface may be roughened to provide surface features defined at least in part by sharp changes in orientation of adjacent parts of the surface.

## Description

### Field of the Invention

The present invention relates to components in ion implanters having surfaces adjacent to the path of the ion beam through the ion implanter. Such surfaces will be prone to deposition and the present invention addresses problems associated with delamination of deposited material.

### Background of the Invention

Ion implanters are used in the manufacture of semiconductor devices and other materials. In such ion implanters, semiconductor wafers or other substrates are modified by implanting atoms of a desired species into the body of the wafer, for example to form regions of varying conductivity.

Ion implanters are well known and generally conform to a common design as follows. An ion source generally comprises an arc chamber in which a hot plasma is generated. The plasma will contain ions of a desired species to be implanted.

An extraction lens assembly produces an electric field that extracts ions from the ion source and forms a mixed beam of ions. Only ions of a particular species are usually required for implantation in a wafer or other substrate, for example a particular dopant for implantation in a semiconductor wafer. The required ions are selected from the mixed ion beam that emerges from the ion source by using a mass analysing magnet in association with a mass resulting slit. By setting appropriate operational parameters on the mass analysing magnet and the ion optics associated therewith, an ion beam containing almost exclusively the required ion species emerges from the mass resolving slit.

This ion beam is transported to a process chamber where the ion beam is incident on a substrate held in place in the ion beam path by a substrate holder. Accordingly, ions are produced in an ion source and transported to a process chamber along an ion beam path.

In addition to the above-described operations, further procedures may be performed. For example, it is common to perform low-energy implants, but this has an associated problem in that a slow moving ion beam is susceptible to space charge blow-up. Accordingly, ions are often accelerated as they are extracted from the ion source to travel along the ion beam path at high energy. The ion beams then pass through a deceleration lens assembly prior to implantation in the wafer. In addition, other ion optics may be included along the ion beam path to steer and shape the ion beam and to prevent loss of current from the ion beam. Other components such as a plasma flood system may be placed along the ion beam path.

The various parts of the ion implanter are operated under the management of a controller, typically a suitably trained person, a programmed computer or the like. A more detailed description of an ion implanter of this general type can be found in US Patent No. 4,754,200.

During normal operation of an ion implanter, material is produced that gets deposited on various components within the ion implanter. This material arises from a number of sources. For example, some material may be lost from the ion beam, such as the species to be implanted or contaminants entrained within the ion beam. Another major source of deposition material is the photo-resist cover that is provided on semiconductor wafers to be implanted. The heat generated by the ion beam striking the wafer causes outgassing of carbon, hydrogen and hydrocarbons that may then deposit on surfaces. Another source of contaminants is material from ion implanter components that surround the ion beam path. If the ion beam strikes such components, material may be sputtered from that surface only to adhere to another surface within the ion implanter. As the surfaces surrounding the ion beam path are typically made from graphite, graphite is a major component in the deposited material.

Clearly, surfaces adjacent to the ion beam are most prone to receiving deposits. As the amount of material deposited accumulates, the chances of the deposits delaminating to form flakes or particles increases. These flakes or particles frequently detach from their host surface and may become entrained in the ion beam. Consequently, the flakes or particles may reach the wafer where they represent a contaminant and may damage the semiconductor material.

### Summary of the Invention

Against this background, and from a first aspect, the present invention resides in an ion implanter component having a surface defining at least in part an ion beam path through the ion implanter, wherein at least a portion of the surface has been roughened.

This is in contrast to the established wisdom of utilising smooth surfaces within the ion implanter. In particular, components carrying voltages are smooth to ensure good electrical field characteristics and to minimise the chance of arcing where the voltage is large. Other components will generally be formed without any subsequent treatment to roughen their surfaces and usually a smoothing process is applied to those as well. However, roughening the surfaces has been found to be advantageous in respect of deposited material. While roughening the surface does not prevent deposition of material, the absence of large continuous surfaces prevents accumulations of deposits large enough to allow delamination and flake formation. In addition, roughening may even aid in trapping deposits and resisting detachment of material from the surface.

Some components are likely to benefit more from surface roughening than others. For example, some components are regularly clipped by the ion beam. The parts of these components regularly clipped by the ion beam do not tend to see large accumulations of deposits. This is most probably because the ion beam serves to clean those surfaces, either by sputtering off deposits as they form or by thermal cycling. However, other components that either never receive direct ion beam strike or only occasionally see ion beam strike will benefit more from surface roughening. In addition, areas of a component regularly clipped by an ion beam, but away from the area where the ion beam strikes the component may also benefit from roughening.

The surface may be roughened to provide a pattern of surface features, for example a regular pattern of surface features. Preferably, the surface features are defined at least in part by sharp changes in orientation of adjacent portions of the surface. In particular, the surface features may be defined at least in part by adjacent faces that meet at a sharp edge.

A variety of surface features or surface patterning may be formed. For example, the surface may be roughened by forming a series of grooves. Preferred ranges of depths of the grooves are: 0.1mm to 10mm, 0.25mm to 7.5mm, and 0.5mm to 5mm. Optionally, the surface may be provided with a series of side-by-side grooves. The side-by-side grooves may be regularly spaced. Preferred ranges for the pitch of these grooves are: 0.1mm to 10mm, 0.25mm to 7.5mm, and 0.5mm to 5mm.

Where grooves are formed in the surface, they may take a variety of shapes, both in the plane of the surface and in cross-section. For example, the grooves may be linear or they may be curved or kinked. In terms of cross-section, v-shaped, u-shaped, saw tooth grooves, and box-like trenches are all currently contemplated.

Optionally, the surface may be roughened by forming two or more series of intersecting grooves. Preferably, first and second series of grooves may be formed with the first and second series orthogonal. The grooves may be v-shaped, thereby forming an array of tetrahedra.

From a second aspect, the present invention resides in an ion implanter component having a surface defining at least in part an ion beam path through the ion implanter, wherein the surface is faceted to provide a plurality of faces separated by edges.

From a third aspect, the present invention resides in an ion implanter component having a surface defining at least in part an ion beam path through the ion implanter, wherein at least a portion of the surface is textured with a pattern comprising surface features with a depth in the range of 0.5mm to 5mm and a pitch in the range of 0.5mm to 5mm.

The present invention also resides in an ion implanter including any of the components described above.

From a fourth aspect, the present invention resides in a method of making an ion implanter component having a surface intended to define at least in part an ion beam path through the ion implanter, the method comprising roughening at least a portion of the surface. The roughening may be performed to produce any of the components described above.

From a fifth aspect, the present invention resides in a method of preventing delamination of deposits accumulated on surfaces defining an ion beam path through an ion implanter, the method comprising providing the ion implanter with any of the components described above.

### Brief Description of the Drawings

In order that the present invention may be better understood, a preferred embodiment will now be described with reference to the accompanying drawings, in which:
Figure 1 is a schematic representation of an ion implanter;
Figure 2a is a perspective view of a roughened surface of a component in accordance with a first embodiment of the present invention such that the surface is provided with v-shaped grooves;
Figure 2b is a section showing the v-shaped grooves of Figure 2a;
Figure 2c is a plan view of the surface shown in Figure 2a;
Figure 3a is a perspective view of a roughened surface of a component in accordance with a second embodiment of the present invention such that the surface is provided with saw-tooth shaped grooves;
Figure 3b is a section showing the saw-tooth shaped grooves of Figure 3a;
Figure 3c is a plan view of the surface shown in Figure 3a;
Figure 4a is a perspective view of a roughened surface of a component in accordance with a third embodiment of the present invention such that the surface is provided with trenches;
Figure 4b is a section showing the trenches of Figure 4a;
Figure 4c is a plan view of the surface shown in Figure 4a;
Figure 5a is a perspective view of a roughened surface of a component in accordance with a fourth embodiment of the present invention such that the surface is provided with fluted channels;
Figure 5b is a section showing the fluted channels of Figure 5a;
Figure 5c is a plan view of the surface shown in Figure 5a;
Figure 6a is a perspective view of a roughened surface of a component in accordance with a fifth embodiment of the present invention such that the surface is provided with intersecting v-shaped grooves thereby to form tetrahedra;
Figure 6b is a section showing the intersecting v-shaped grooves of Figure 6a; and
Figure 6c is a plan view of the surface shown in Figure 6a.

### Detailed Description of the Invention

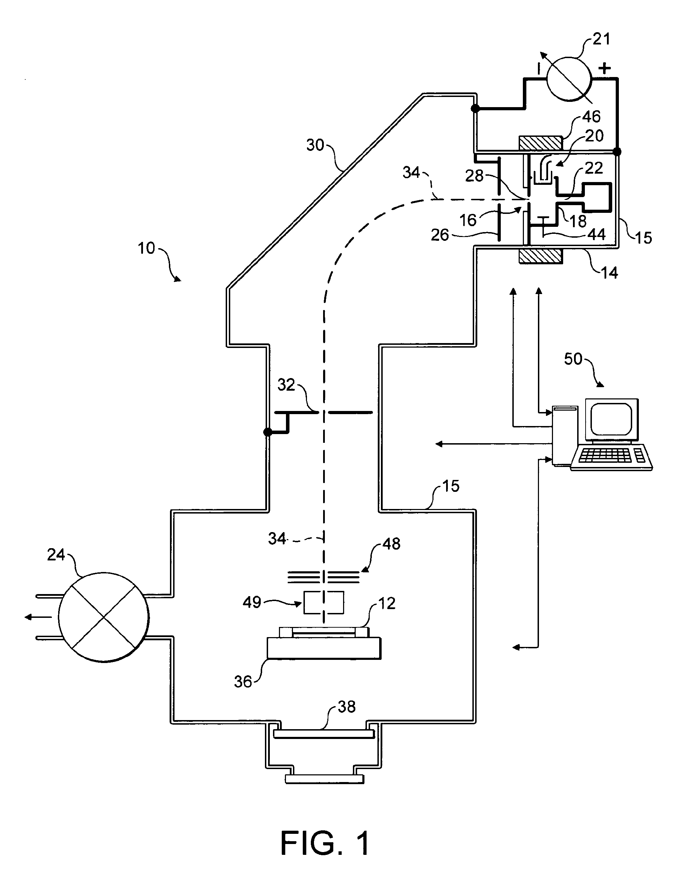

In order to provide a context for the present invention, an exemplary application is shown in Figure 1, although it will be appreciated this is merely an example of the application of the present invention and is in no way limiting.

Figure 1 shows an ion implanter 10 for implanting ions in semiconductor wafers 12 that may be used in accordance with the present invention. The ion implanter 10 comprises a vacuum chamber 15 pumped through valve 24. Ions are generated by ion source 14 and are extracted by an extraction lens assembly 26 to form an ion beam 34. In this embodiment this ion beam 34 is steered and shaped through the ion implanter 10 such that the ion beam 34 passes through a mass analysis stage 30. Ions of a desired mass are selected to pass through a mass resolving slit 32 and then conveyed onward along an ion beam path 34 towards the semiconductor wafer 12. Before reaching the semiconductor wafer 12, the ions are decelerated by deceleration lens assembly 48 and pass through a plasma flood system 49 that acts to neutralise the ion beam 34.

The ion source 14 generates an ion beam of a desired species. The ion source 14 generally comprises an arc chamber 16 containing a cathode 20 located one end thereof. The ion source 14 may be operated such that an anode is provided by the walls 18 of the arc chamber 16. The cathode 20 is heated sufficiently to generate thermal electrons. Thermal electrons emitted by the cathode 20 are attracted to the anode, the adjacent chamber walls 18 in this case. The thermal electrons ionise gas molecules as they traverse the arc chamber 16, thereby forming a plasma and generating the desired ions.

The path followed by the thermal electrons may be controlled to prevent the electrons merely following the shortest path to the chamber walls 18. A magnet assembly 46 provides a magnetic field extending through the arc chamber 16 such that thermal electrons follow a spiral path along the length of the arc chamber 16 towards counter cathode 44 located at the opposite end of the arc chamber 16.

A gas feed 22 supplies the arc chamber 16 with either the species to be implanted or a precursor gas species. The arc chamber 16 is held at a reduced pressure within the vacuum chamber 15. Thermal electrons travelling through the arc chamber 16 ionise the gas molecules present in the arc chamber 16 and may also crack molecules. The ions created in the plasma will also contain trace amounts of contaminant ions, e.g. those generated from the material of the chamber walls that is usually graphite.

Ions from within the arc chamber 16 are extracted through an exit aperture 28 provided on a front plate 27 of the arc chamber 16 using a negatively biased (relative to ground) extraction electrode 26. A potential difference is created between the ion source 14 and the following mass analysis stage 30 by a power supply 21 such that the extracted ions are accelerated, the ion source 14 and mass analysis stage 30 being electrically isolated from each other by an insulator (not shown).

The mixture of extracted ions are then passed through the mass analysis stage 30 so that the mixture passes around a curved path under the influence of a magnetic field. The radius of curvature travelled by any ion is determined by its mass, charge state and energy. The magnetic field is controlled so that, for a set beam energy, only those ions with a desired mass-to-charge ratio energy exit along a path coincident with the mass resolving slit 32. The ion beam 34 is then transported to the target, i.e. the substrate wafer 12 to be implanted or a beamstop 38 when there is no wafer 12 in the target position. Before arriving at the wafer 12 or beamstop 38, the ions are decelerated using a deceleration lens assembly 48 positioned between the mass analysis stage 30 and upstream of the target position. The deceleration lens assembly 48 is followed by a plasma flood system 49 that operates to produce a flood of electrons that are available to the semiconductor wafer 12 to neutralise the effect of the incident positive ions.

A semiconductor wafer 12 will be mounted on a wafer holder 36, wafers 12 being successively transferred to and from the wafer holder 36 for serial implantation. Alternatively, parallel processing may be used where many wafers 12 are positioned on a carousel 36 that rotates to present the wafers to the instant ion beam in turn.

A controller is shown at 50 that comprises a suitably programmed computer. The controller 50 is provided with software for managing operation of the ion implanter 10.

In general, the ion implanter 10 will be susceptible to deposition from materials such as graphite and photo-resist. In particular, the surfaces that are close to the ion beam path 34 will particularly see deposition of material and material that later breaks free from those surfaces is more likely to become entrained in the ion beam. As mentioned above, excessive accumulation of deposited material leads to delamination such that flakes detach and become entrained in the ion beam. These flakes may be of varying sizes and may be further broken up to result in a large amount of very small particles (sub-micrometer). These particles may deposit and stick to the semiconductor wafers 12. In order to alleviate this problem, certain surfaces may be adapted to prevent the accumulation of particulates. As will be appreciated, to prevent deposition of material is difficult to achieve, but action may be taken to prevent the formation of large areas of material that may later be prone to delamination.

In particular, components within the ion implanter 10 may be provided with roughened surfaces. Such surfaces may be roughened to interrupt the otherwise large surface area and so prevent large flakes of material accumulating. Electrically passive surfaces are particularly suitable to such treatment. Surfaces that are electrically active, and in particular those that carry high voltages, are less susceptible to such treatment as the roughening may have adverse effects on their electrical properties. For example, roughening of the surface carrying a high voltage may lead to an increased risk of arcing.

Surfaces that are considered particularly suitable for roughening include those provided in the flight tube, those provided the back side of aperture plates, the mass analyser 30 including the mass resolving slit 32, the plasma flood system 49, and electrodes of the deceleration lens electrode assembly 48 that do not carry high voltages.

Many forms of surface roughening may be used to prevent flake formation and there follows a description of some

### preferred embodiments.

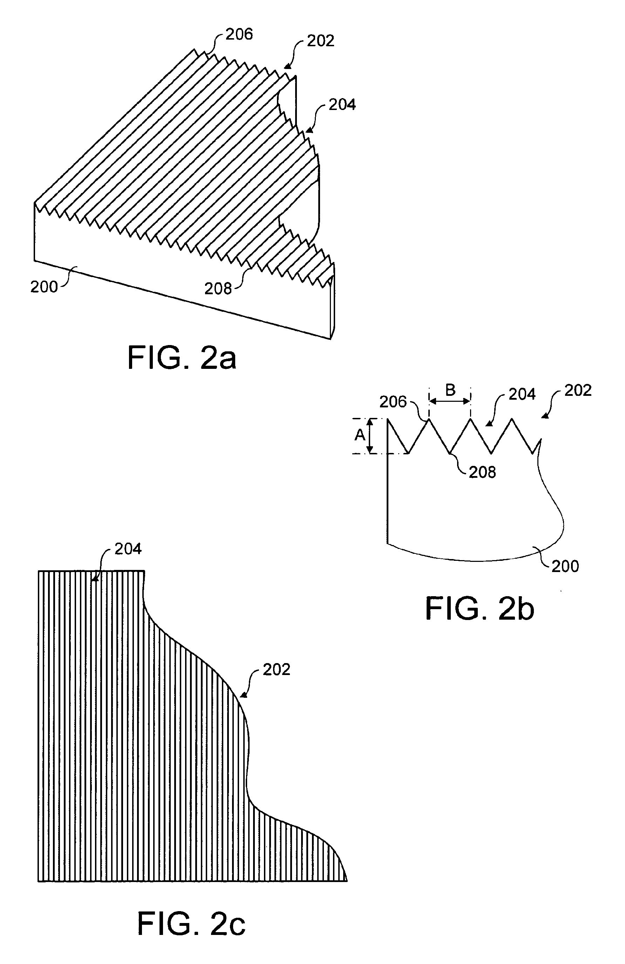

Figures 2a to 2c show a surface patterning that may be used in accordance with a first embodiment of the invention. A portion of a component 200 within the ion implanter 10 is shown in Figures 2a to 2c that is provided with a roughened surface 202. The surface 202 bears a series of abutting, linear v-shaped grooves 204 arranged side-by-side so as to form successive sharp ridges 206 and sharp troughs 208. The size of the grooves 204 may be characterised by the dimensions A and B that correspond to depth and pitch respectively, as indicated on Figure 2b. These dimensions may take various values, and need not all be the same. Typical values for A or B may be in the range 0.5mm to 5mm.

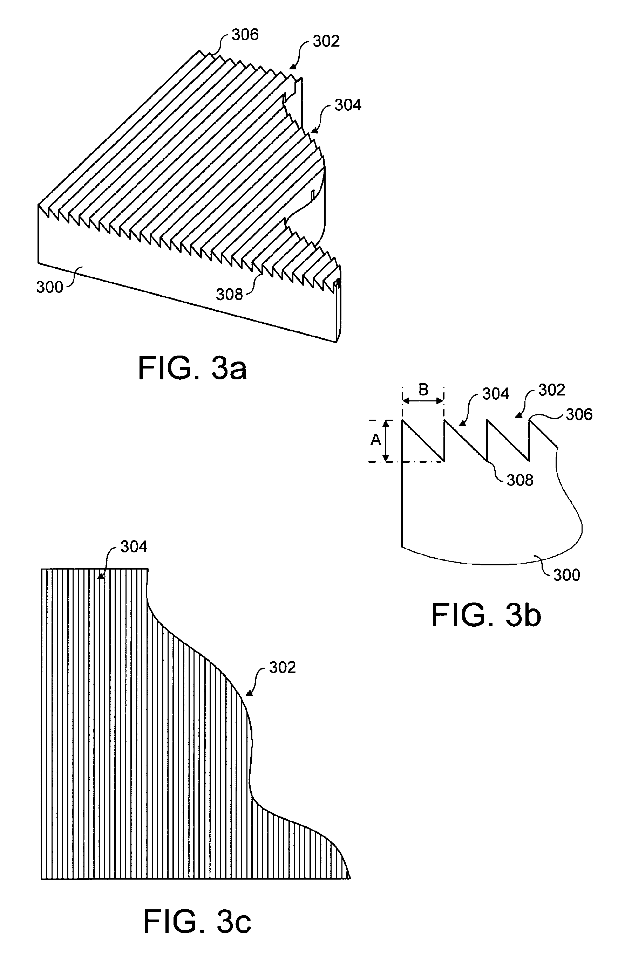

Figures 3a to 3c show a second embodiment of the present invention. Again, a portion of a component 300 within an ion implanter 10 is shown that is provided with a roughened surface 302. Once more, the surface 302 comprises a series of grooves 304. To illustrate that the sides of the grooves 304 need not adopt the same angle as per the embodiment of Figures 2a to 2c, the grooves 304 of Figures 3a to 3c have one upright side and one sloping side. This arrangement results in a saw-tooth profile as is most evident from the side view of Figure 3b. The grooves 304 may be characterised by the dimensions A and B corresponding to depth and pitch. As for the embodiment of Figures 2a to 2c, typical sizes of 0.5mm to 5mm would be suitable.

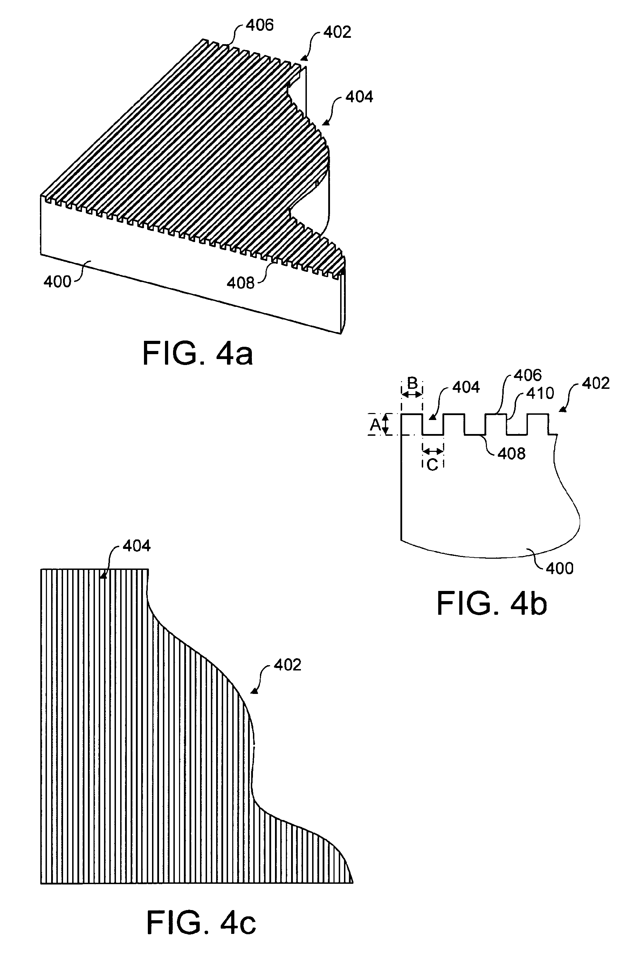

While the embodiments shown in Figures 2a to 2c and Figures 3a to 3c have grooves 204 and 304 that abut to form sharp ridges 206 and 306, the grooves may instead be separated. This will result in flat sections between adjacent grooves 204, 304. These flat sections should have small width, for example between 0.5mm and 5mm, to prevent flake formation. An example of a roughened surface 402 having grooves 404 separated by flat sections 404 is shown in Figures 4a to 4c. In these Figures, the component 400 is provided with grooves 404 in the form of a series of parallel trenches 404. The trenches 404 have flat bottoms 408 and vertical sides 410. Typical depths A are 0.5mm to 5mm and typical widths B for the flat tops 406 and flat bottoms 408 are also 0.5mm to 5mm.

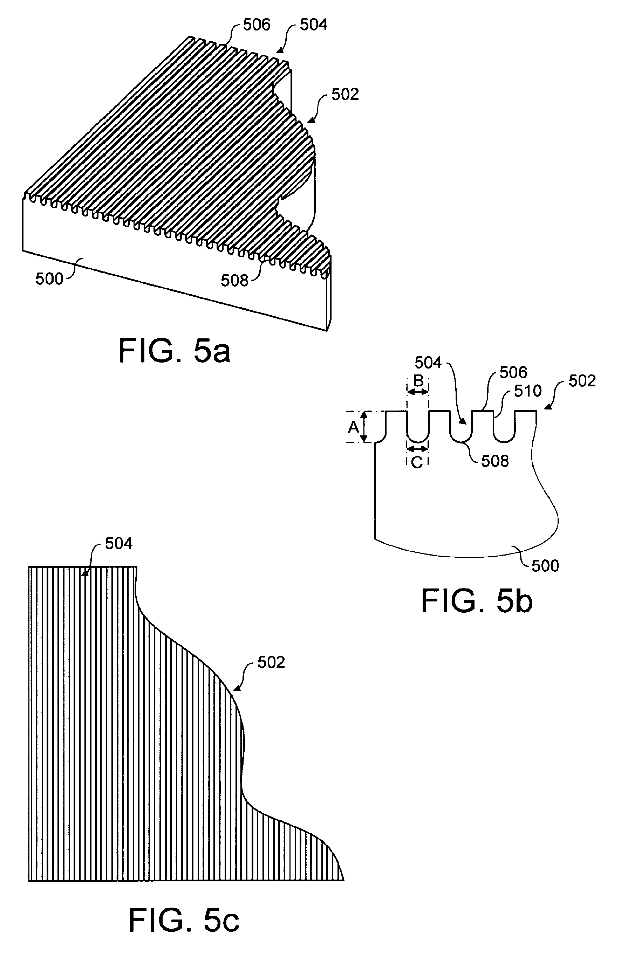

Figures 5a to 5c show a fourth embodiment of the present invention where a component 500 is provided with a roughened surface 502 that comprises a series of fluted channels 504. As is best seen in Figure 5b, the generally u-shaped channels 504 are separated by flat sections 506. As will clear from the above, the fluted channels 504 may abut so as to form sharp ridges 506. The angle subtended by each fluted channel 504 may be less than the 180° shown in Figures 5a and 5b.

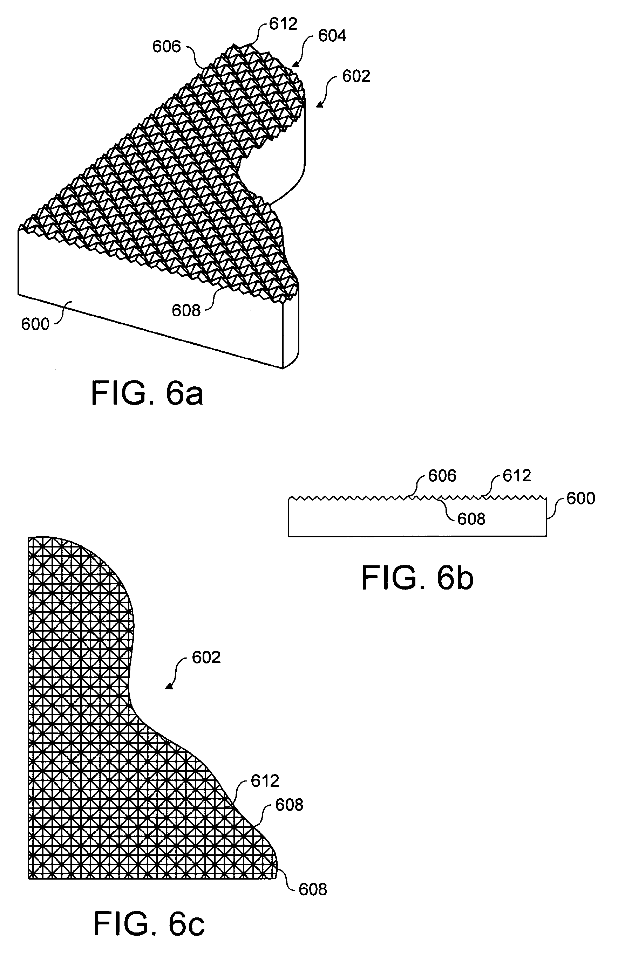

The embodiments of Figures 2 to 5 all show side-by-side grooves 204, 304, 404 and 504. However, intersecting arrays of grooves may also be used to roughen the surfaces 202, 302, 402 and 502. For example, two arrays of side-by-side grooves 204, 304, 404, 504 may be formed at an angle to one another so as to intersect. Figures 6a to 6c show such an arrangement where a surface 602 has been roughened by forming first and second series of v-shaped grooves 604. Each series of grooves 604 comprise parallel, abutting grooves 604 that form a series of troughs 608. The two series are arranged to be orthogonal such that the intersecting troughs 608 cut through what would be the ridges 606 to form a regular array of tetrahedra 612.

The ridged patterns formed on the surfaces 202, 302, 402, 502 and 602 means that there are no extensive flat areas on which depositions may accumulate to a sufficient size to delaminate and form flakes. Accordingly, while deposition will continue, large flakes do not result that may later detach from the surfaces 202, 302, 402, 502 and 602. In fact, the patterned surfaces 202, 302, 402, 502 and 602 perform far better in retaining deposited material that might otherwise detach, for example due to incidence of the ion beam 34 or through thermal cycling.

The surfaces 202, 302, 402, 502 and 602 may be roughened in any number of ways. How the pattern is formed may be dependent upon the material of the surface 202, 302, 402, 502 and 602 itself. For example, metal surfaces may be machined to form a required pattern or they may be pressed to form the pattern. Machining may include sanding or grinding. For other materials such as graphite, other techniques such as ablation, sputtering or etching may be used (graphite parts are usually also machined similarly to metal parts).

As will be appreciated by the person skilled in the art, variations may be made to the above embodiment without departing from the scope of the invention defined by the claims.

For example, all of the above embodiments show a series of linear grooves formed in a surface. However, the grooves need not be linear. For example, the grooves may be curved or kinked. Moreover, the grooves need not all be the same shape or all the same size.

## Claims

1. An ion implanter component having a surface defining at least in part an ion beam path through the ion implanter, wherein at least a portion of the surface has been roughened.

2. The component of claim 1, wherein the portion of the surface has been roughened to provide a pattern of surface features.

3. The component of claim 2, wherein the portion of the surface has been roughened to provide a regular pattern of surface features

4. The component of claim 2 or claim 3, wherein the portion of the surface has been roughened to provide surface features defined at least in part by sharp changes in orientation of adjacent parts of the surface.

5. The component of claim 4, wherein the portion of the surface has been roughened to provide surface features defined at least in part by adjacent faces that meet at a sharp edge.

6. The component of any preceding claim, wherein the portion of the surface has been roughened to provide a series of grooves.

7. The component of claim 6, wherein the grooves have a depth in a range of 0.1mm to 10mm, 0.25mm to 7.5mm, or 0.5mm to 5mm.

8. The component of claim 6 or claim 7, wherein the portion of the surface has been roughened to provide a series of side-by-side grooves.

9. The component of claim 8, wherein the series comprises grooves with a regular spacing in a range of: 0.1mm to 10mm, 0.25mm to 7.5mm, or 0.5mm to 5mm.

10. The component of any of claims 6 to 9, wherein the grooves have any of the following cross-sectional profiles: v-shape, u-shaped, saw tooth or box-like trenches.

11. The component of any of claims 6 to 10, wherein the portion of the surface has been roughened to provide at least two intersecting series of grooves.

12. The component of claim 11, wherein first series and second series are disposed orthogonally.

13. The component of claim 12, wherein the first and second series comprise v-shaped grooves that intersect to form an array of tetrahedra.

14. An ion implanter component having a surface defining at least in part an ion beam path through the ion implanter, wherein the surface is faceted to provide a plurality of faces separated by edges.

15. An ion implanter component having a surface defining at least in part an ion beam path through the ion implanter, wherein at least a portion of the surface is textured with a pattern comprising surface features with a depth of between 0.5mm and 5mm, and a pitch of between 0.5mm and 5mm.

16. An ion implanter including a component according to any preceding claim.

17. A method of making an ion implanter component having a surface intended to define at least in part an ion beam path through the ion implanter, the method comprising roughening at least a portion of the surface.

18. A method of preventing delamination of deposits accumulated on surfaces defining an ion beam path through an ion implanter, the method comprising providing the ion implanter with a component according to any of claims 1 to 15.
